## Europäisches Patentamt

## European Patent Office

## Office européen des brevets

(11) Veröffentlichungsnummer: **0 170 119**
**B1**

(12) **EUROPÄISCHE PATENTSCHRIFT**

(45) Veröffentlichungstag der Patentschrift:
12.10.88

(21) Anmeldenummer: 85108601.7

(22) Anmeldetag: 10.07.85

(51) Int. Cl.⁴: **C 30 B 15/06**

(54) **Verfahren und Vorrichtung zum Herstellen von bandförmigen Siliziumkristallen mit horizontaler Ziehrichtung.**

(30) Priorität: 31.07.84 DE 3428257

(43) Veröffentlichungstag der Anmeldung:
05.02.86 Patentblatt 86/6

(45) Bekanntmachung des Hinweises auf die Patenterteilung:
12.10.88 Patentblatt 88/41

(84) Benannte Vertragsstaaten:
DE FR GB IT

(56) Entgegenhaltungen:
DE-A-2 850 805
GB-A-2 067 920

(73) Patentinhaber: **Siemens Aktiengesellschaft Berlin
und München, Wittelsbacherplatz 2, D-8000
München 2 (DE)**

(72) Erfinder: **Falckenberg, Richard, Dr. rer. nat.,
Hofen 21, D-8952 Wald (DE)**
Erfinder: **Grabmaier, Josef, Dr. rer. nat., Am
Seefeld 17, D-8137 Berg 1 (DE)**

**Beschreibung**

Die Erfindung betrifft ein Verfahren zum Herstellen von bandförmigen Siliziumkristallen für Halbleiterbauelemente, insbesondere für Solarzellen, bei dem ein gegenüber der Siliziumschmelze resistenter Trägerkörper in horizontaler Richtung tangierend über die in einer Wanne befindliche Schmelze gezogen und mit Silizium beschichtet wird und bei dem der Trägerkörper zugleich Kristallisationskeim für den Aufbau des kristallinen Siliziums ist, sowie eine Vorrichtung zur Durchführung des Verfahrens.

Eine solche Verfahrensweise ist aus der US-PS-4 305 776 zu entnehmen. Dabei wird als Keimbildungszentrenträger ein mit einem speziellen Löchersystem versehenes transportables Band, zum Beispiel ein Graphitnetz, verwendet und die Kristallisation des schmelzflüssigen Silizium in den Maschen des Netzes durch einen Kühlgasstrom bewirkt.

Auf diese Weise kann kostengünstiges Silizium für Solarzellen hergestellt werden, da das Silizium ohne Zwischenschritte aus der Schmelze gleich in die Flächenform übergeführt wird.

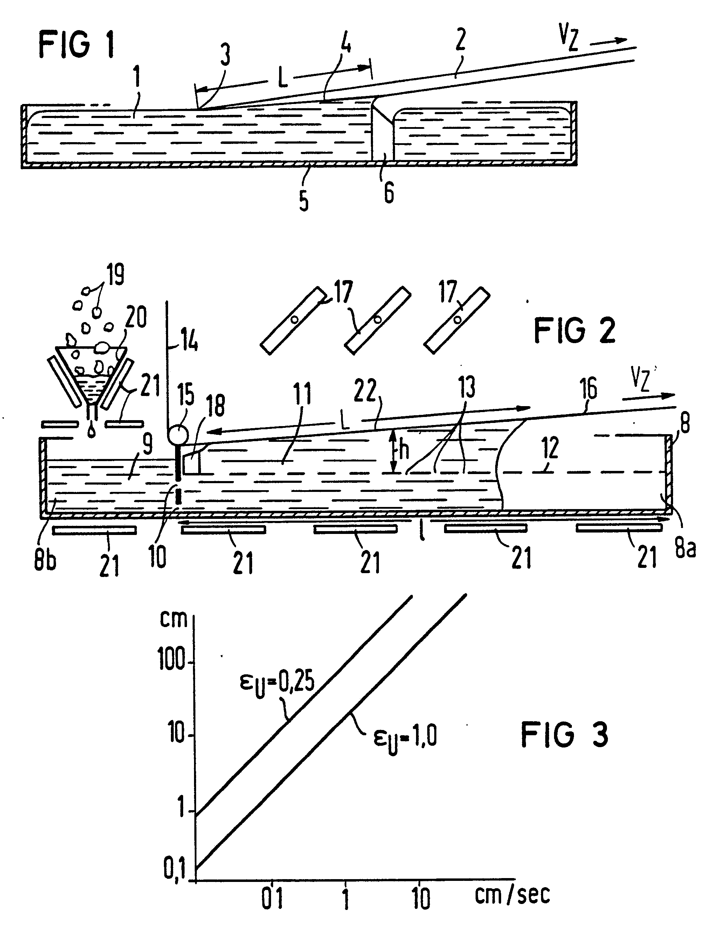

Neben dem Wirkungsgrad der Solarzellen aus diesem Flächensilizium ist die Flächengeschwindigkeit, mit der dieses Material hergestellt wird, das Hauptkriterium für die Wirtschaftlichkeit des Verfahrens. Die Flächengeschwindigkeit ist prinzipiell begrenzt durch die bei der Kristallisation freiwerdende latente Wärme, die in dem Maß, in dem sie entsteht, auch abgeführt werden muß. Horizontalverfahren bieten dabei wegen des günstigen Verhältnisses von Kristallisationsfläche zu wärmeabführender Fläche beträchtliche Vorteile gegenüber Vertikalverfahren. So lassen sich mit dem aus einem Aufsatz von Bates und Jewett aus den Proceedings of the Flat-Plate Solar Array Project Research Forum on the High-Speed Growth and Characterization of Crystals for Solar Cells, 25. - 27. Juli 1983, Port St. Lucie, Florida, auf den Seiten 297 bis 307 beschriebenen sogenannten LASS (= low angle silicon sheet)-Verfahren Siliziumbänder mit Geschwindigkeiten bis zu etwa 80 cm/min ziehen. Dieses Verfahren verwendet keinen Trägerkörper für die Beschichtung. Es hat aber zwei Nachteile, die anhand der Figur 1 näher erklärt werden:

1.  Die Kristallisationsgeschwindigkeit muß an der (in Ziehrichtung $v_z$ gesehen; siehe Pfeil) vorderen Kante 3 der Kristallisationsfläche 4 (= Führungskante des wachsenden Bandes 2) gleich groß sein wie die Ziehgeschwindigkeit. Bei hohen Ziehgeschwindigkeiten läßt sich dies nur durch Unterkühlung der Schmelze 1 und Dendritenwachstum erreichen. Dendritenwachstum bedeutet aber wegen der damit verbundenen Unregelmäßigkeiten der Schichtausbildung eine Herabsetzung des Wirkungsgrades der aus diesem Material gefertigten Solarzellen.
2.  Die gewünschten Abmessungen des Bandes (Breite, Dicke) können nicht über längere Zeit konstant gehalten werden. Ursache dafür ist die kurze Zeitspanne t, während der die Siliziumschicht sich bilden muß und Kontakt mit der Schmelze hat (Verweilzeit). Sie ergibt sich aus der Länge L der Kristallisationsfläche 4 und der Ziehgeschwindigkeit $v_z$ zu t = L/$v_z$ = 2/80 = 1,5 sec. Zufällige Temperaturschwankungen in der Schmelze können wegen der endlichen Wärmekapazität von Schmelzgefäß 5 und Schmelze 1 in dieser kurzen Zeit nicht ausgeregelt werden. Sie wirken sich voll auf den für das Schichtwachstum wesentlichen Temperaturgradienten in der Schmelze 1 aus, das heißt, sie führen zu Geometrieänderungen des wachsenden Siliziumbandes 2. Mit dem Bezugszeichen 6 ist der im Schmelzgefäß 5 angebrachte Abstreifer für die Siliziumschmelze 1 bezeichnet.

Die Aufgabe, die der Erfindung zugrundeliegt, besteht in der Vermeidung der durch das LASS-Verfahren bedingten Nachteile und in der Herstellung eines Siliziumbandes mit einstellbarer Breite und konstanter Schichtdicke bei hohen Ziehgeschwindigkeiten.

Diese Aufgabe wird durch ein Verfahren der eingangs genannten Art dadurch gelöst, daß

a)  als Trägerkörper und Kristallisationskeimbildner in Ziehrichtung parallel verlaufende Fäden aus gegenüber der Siliziumschmelze einen höheren Emissionsfaktor ε aufweisenden Material verwendet werden,
b)  für die Schmelze eine Wanne verwendet wird, deren Länge l so bemessen ist, daß eine Kontaktlänge L zwischen Schmelze und tangierenden Trägerkörper mit L kleiner/gleich l so eingestellt werden kann, daß L = $v_z$ . t, wobei $v_z$ die Ziehgeschwindigkeit und t die Verweilzeit bedeuten,
c)  die Ziehrichtung ($v_z$) kleiner/gleich 10 Grad gegen die Horizontale geneigt eingestellt wird und
d)  über der Schmelze Reflektoren angeordnet werden, die im Zusammenhang mit den unter der Bodenfläche der Wanne befindlichen Heizern die Abstrahlung der Siliziumschmelzenoberfläche so regulieren, daß die Temperatur im Bereich des Schmelzpunktes von Silizium ($T_M$ = 1420° C) bleibt.

Es liegt im Rahmen der Erfindung, daß für die Schmelze eine Wanne verwendet wird, deren Tiefe h auf der ganzen Länge l oder auf einer Teillänge l' so bemessen ist, daß sich eine benetzende Enddicke $d_E$ des Siliziumbandes im Bereich von 100 bis 140 μm erreichen läßt nach $d_E$ $\geq$ 0,05 h.

Ein weiterer Aspekt der Erfindung liegt in einer Vorrichtung zur Durchführung des Verfahrens, deren Merkmale in Anspruch 6 dargelegt sind.

Weitere Ausgestaltungen der Erfindung ergeben sich aus den Unteransprüchen.

Die Erfindung wird im einzelnen anhand der Figuren 1 bis 3 noch näher erläutert. Dabei zeigt

die Figur 1 eine Tiegelanordnung nach dem in der Beschreibungseinleitung bereits beschriebenen LASS-Verfahren,

die Figur 2 in schematischer Darstellung eine Vorrichtung zur Durchführung des Verfahrens nach der Lehre der Erfindung und

die Figur 3 in einem Diagramm die Abhängigkeit der Ziehgeschwindigkeit $v_z$ (cm/sec) von der Länge L (cm) der Kontaktfläche Siliziumschmelze/Siliziumband für eine Endschichtdicke $d_E$ von 300 μm bei einer Umgebungstemperatur bis zu 300°C.

**Figur 2:** Für den horizontalen Ziehprozeß nach der Lehre der Erfindung wird eine Schmelzwanne mit einem Teil 8a verwendet, dessen Länge 1 mindestens gleich oder größer ist als die Kontaktlänge L, die sich aus der Ziehgeschwindigkeit $v_z$ und der Verweilzeit t der Fäden 14 auf bzw. in der Schmelze 11 ergibt: L = $v_z$ . t. Der Teil 8b der Schmelzwanne 8 dient als Reservoir für die Vorratsschmelze 9, die durch Kanäle 10 mit der Hauptschmelze 11 verbunden ist. Im Teil 8a der Schmelzwanne 8 befindet sich zur Vermeidung von Konvektionsströmungen eine in horizontaler Richtung sich erstreckende höhenverstellbare Bodenplatte 12, die mit Durchbrechungen 13 für den Durchtritt der Schmelze versehen ist.

Beim Ziehprozeß wird dafür gesorgt, daß gleichzeitig auf der gesamten Länge L der Schmelze 11 Kristallwachstum erfolgen kann, indem als Kristallisationskeimbildungszentren dienende Graphitfäden 14 mit der Oberfläche der Schmelze 11 in Kontakt gebracht werden, wobei die Fäden 14 tangierend über die Oberfläche der Schmelze 11 gezogen werden. Die Fäden 14 sind parallel angeordnet und werden von einer Umlenkrolle 15, die sich über der Schmelzwanne 8 befindet und vorzugsweise zur Erhöhung der Wärmeableitung durch die Graphitfäden 14 wassergekühlt ist, der Schmelzenoberfläche ( = Kristallisationsfläche 22) zugeführt. Der Abstand der Fäden 14 liegt im Bereich von 2 bis 15 mm.

Die Graphitfäden 14 haben einen Emissionskoeffizienten $\varepsilon_S$ = 0,6; $\varepsilon_L$ der Siliziumschmelze 11 beträgt hingegen nur 0,3. Man erreicht dadurch, daß die unmittelbare Umgebung der Fäden 14 sich schneller abkühlt als die Siliziumschmelze 11 selbst. Somit kristallisiert bei geeigneter Schmelzentemperatur $T_L \approx T_M$ ($T_M$ = Temperatur des Schmelzpunktes) längs der Fäden 14 Silizium aus. Die Kristallisation 22 erfolgt völlig unabhängig von der Ziehgeschwindigkeit $v_z$ der Fäden 14 und ist lediglich eine Funktion der Oberflächentemperatur und des Temperaturgradienten in der Schmelze 11. Von den Fäden 14 breitet sich die erstarrende Schicht 22 seitlich und in der Tiefe aus, da $\varepsilon_S$ des festen Siliziums gleich 0,46 ist, also ebenfalls höher liegt als bei flüssigem Silizium. Man kann diese Art der Kristallisation als Flächenkristallisation bezeichnen. Bei dem in der US-PS-4 305 776 beschriebenen Verfahren geht die Kristallistion vorwiegend von der gekühlten Schmelzenoberfläche aus. Das Graphitnetz wirkt auf der Schmelzoberfläche als Abdeckkörper.

Die Ziehrichtung $v_z$ (siehe Pfeil) wird gemäß der Lehre der Erfindung kleiner/gleich 10 Grad gegen die Horizontale geneigt eingestellt. Die Badlänge, auf der eine Kristallisation stattfindet, ergibt sich aus Ziehgeschwindigkeit $v_z$ und erforderlicher Verweilzeit t der wachsenden Schicht 22 in der Schmelze zu L = $v_z$ . t (siehe auch Figur 3).

Die Verweilzeit t läßt sich bei gegebener Enddicke $d_E$ der Siliziumschicht (Siliziumband 16) aus der Wachstumsgeschwindigkeit berechnen. Parameter sind die von der Oberfläche der Schmelze 11 bzw. der Schicht 22 abgestrahlte Leistung sowie die Temperaturgradienten in der Schicht 22 und Schmelze 11, wobei der Temperaturgradient in der Schmelze 11 von deren Höhe h abhängt. Insbesondere lassen sich die Parameter so einstellen, daß sich die Schichtdicke $d_E$ asymptotisch einer Enddicke nähert. Diese Enddicke $d_E$ ist mit der Schmelzenhöhe h verknüpft: $d_E$ größer/gleich 0,05 h. Einer Schmelzenhöhe von 3 mm entspricht zum Beispiel eine stabile Enddicke der Siliziumschicht 16 von 150 μm. Läßt man das entstandene Band 16 unter diesen Bedingungen längere Zeit über die Schmelze 11 gleiten, so können eventuell vorhandene Unregelmäßigkeiten der Schichtdicke ausgeglichen werden.

Die Temperaturgradienten werden durch Reflektoren 17 geregelt, die über der Schmelz (11)- bzw. Schichtoberfläche 22 angebracht sind. Die Reflektoren 17 sind als Klappen ausgeführt, deren Winkelstellung die Größe des Strahlungsverlustes regelt. Eine weitere Regelungsmöglichkeit besteht in der Auswahl eines geeigneten Reflektormaterials bzw. im Wechsel des Materials, wobei Reflektorplatten verschiedenen Materials auf eine Drehachse in Form eines Prismas angeordnet sein können. Aufgedampfte Beläge können durch eine Glimmentladung während einer Drehung entfernt werden.

In der Schmelzwanne 8 ist an der den einlaufenden (noch unbeschichteten) Fäden 14 zugewandten Seite ein Querbalken 18 aus Graphit oder Siliziumcarbid eingefügt. Er verhindert, daß die Siliziumschmelze 11 mit den Fäden 14 bzw. dem entstehenden Siliziumband 16 mitgezogen wird (bedingt durch Haftspannung zwischen Siliziumschmelze 11 und Graphitbalken 18).

Die als Keimbildner wirkenden Fäden 14 dienen zugleich dazu, die kristallisierte Schicht 16 in Ziehrichtung von der Schmelze 11 abzuziehen, sobald die gewünschte Enddicke $d_E$ erreicht ist. Als Fadenmaterial wird neben Graphit auch Siliziumcarbid, Quarz (eventuell mit einer Graphitschicht überzogen) und Aluminiumoxid verwendet.

Die Siliziumnachführung 19 besteht aus einem Schmelztrichter 20 und der Teilwanne 8b, die wie bereits beschrieben mit der Hauptwanne 8a durch Kanäle 10 in Verbindung steht. Trichter 20 und Wannenteile 8a, 8b sind getrennt beheizbar, wobei die Heizung des Wannenteils 8b so geregelt wird, daß die von 8b nach 8a strömende Schmelze 9 die gleiche Temperatur hat, wie die bereits im Wannenteil 8a befindliche Schmelze 11. Mit dem Bezugszeichen 21 sind die verschiedenen, für die Beheizung der Wannenteile 8a, 8b und des Schmelztrichters 20 dienenden Heizer bezeichnet.

Figur 3 zeigt die Abhängigkeit zwischen der Kontaktlänge L in cm ( = Beginn der Flächenkristallisation an den Fäden 14 bis zum beschichteten Siliziumband 16) und der Ziehgeschwindigkeit $v_z$ in cm/sec für verschiedene Emissionsfektoren $\varepsilon v_U$ (U = Umgebung) der Schmelzenabdeckung (Reflektoren) für eine Endschichtdicke von 300 μm und eine Umgebungstemperatur bis zu 300°C. Aus dem Diagramm ist zu entnehmen, daß Ziehgeschwindigkeiten im Bereich von 1 cm/sec eine Kontaktlänge L von 17 cm erfordern und Ziehgeschwindigkeiten im Bereich von 10 cm/sec Kontaktlängen von 170 cm entsprechen.

**Patentansprüche**

1. Verfahren zum Herstellen von bandförmigen Siliziumkristallen für Halbleiterbauelemente, insbesondere für Solarzellen, bei dem ein gegenüber der Siliziumschmelze resistenter Trägerkörper in horizontaler Richtung tangierend über die in einer Wanne befindliche Schmelze gezogen und mit Silizium beschichtet wird und bei dem der Trägerkörper zugleich Kristallisationskeim für den Aufbau des kristallinen Siliziumbandes ist, <u>dadurch gekennzeichnet</u>, daß

a) als Trägerkörper und Kristallisationskeimbildner in Ziehrichtung parallel verlaufende Fäden (14) aus gegenüber der Siliziumschmelze (11) einen höheren Emissionsfaktor $\varepsilon$ aufweisenden Material verwendet werden,

b) für die Schmelze (11) eine Wanne verwendet wird, deren Länge l so bemessen ist, daß eine Kontaktlänge L zwischen Schmelze und tangierenden Trägerkörper mit L kleiner/gleich l so eingestellt werden kann, daß L = $v_z$ . t, wobei $v_z$ die Ziehgeschwindigkeit und t die Verweilzeit bedeuten,

c) die Ziehrichtung ($v_Z$) kleiner/gleich 10 Grad gegen die Horizontale geneigt eingestellt wird und

d) über der Schmelze (11) Reflektoren (17) angeordnet werden, die im Zusammenwirken mit den unter der Bodenfläche der Wanne befindlichen Heizern die Abstrahlung der Siliziumschmelzenoberfläche (11, 22) so regulieren, daß die Temperatur im Bereich des Schmelzpunktes von Silizium ($T_M$ = 1420°C) bleibt.

2. Verfahren nach Anspruch 1, <u>dadurch gekennzeichnet</u>, daß für die Schmelze (11) eine Wanne verwendet wird, deren Tiefe h auf der ganzen Länge l oder auf einer Teillänge l' so bemessen ist, daß sich eine konstante Enddicke $d_E$ des Si-Bandes im Bereich von 100 - 400 μm erreichen läßt nach $d_E$ größer/gleich 0.05 h.

3. Verfahren nach Anspruch 1 und 2, <u>dadurch gekennzeichnet</u>, daß als Material für die Fäden (14) Graphit, Siliziumcarbid, Quarz, graphitierter Quarz und Aluminiumoxid, verwendet wird.

4. Verfahren nach mindestens einem der Ansprüche 1 bis 3, <u>dadurch gekennzeichnet</u>, daß der Abstand der Fäden (14) in einem Bereich zwischen 2 und 15 mm eingestellt wird.

5. Verfahren nach mindestens einem der Ansprüche 1 bis 4, <u>dadurch gekennzeichnet</u>, daß die Ziehgeschwindigkeit $v_z$ bei einer Schichtdicke des Siliziumbandes (16) von ca. 300 μm und einer Kontaktlänge L von 150 bis 200 cm auf ca. 10 cm/sec eingestellt wird.

6. Vorrichtung zur Durchführung des Verfahrens nach mindestens einem der Ansprüche 1 bis 5, <u>gekennzeichnet durch</u> folgende Merkmale:

a) eine die Siliziumschmelze (11) aufnehmende, vom Boden beheizbare Schmelzwanne (8), die aus einem Wannenteil (8a) mit der Länge l und aus einem als Schmelzenreservoir dienenden Wannenteil (8b) besteht und im Wannenteil (8a) zur Trennung in einen oberen und unteren Wannenbereich eine, in horizontaler Richtung sich erstreckende, mit Durchbrechungen (13) versehene Bodenplatte (12) enthält und der Wannenteil (8a) eine Länge l aufweist, die bei Gebrauch der Vorrichtung größer/gleich der Kontaktlänge L (mit L = $v_z$ . t) ist,

b) eine, außerhalb des Schmelzwannenbereiches (8) angeordnete Antriebsvorrichtung, durch welche eine Ziehrichtung $v_Z$ kleiner/gleich 10 Grad gegen die Horizontale geneigt einstellbar ist,

c) eine, seitlich über dem Schmelzwannenteil mit der Länge l (8a) angeordnete Umlenkrolle (15) für die, die Keimbildungszentren bewirkenden, vorzugsweise aus Graphit bestehenden Fäden (14),

d) ein, im unteren Teil des Schmelzwannenteils mit der Länge l (8a) angeordnetes Kanalsystem (10), welches in Verbindung mit dem als Reservoir für die Vorratsschmelze (9), dienendes Wannenteil (8b) steht und vor der eigentlichen Ziehvorrichtung (15) angeordnet ist,

e) einen, im oberen Teil der Schmelzwanne (8a) an der den einlaufenden Fäden (14) zugewandten Seite befindlichen Graphitbalken (18) und

f) über dem Schmelzwannenteil (8a) angeordnete, bezüglich ihrer Stellung zur Schmelzoberfläche (11, 22) regelbare Reflektoren (17).

7. Vorrichtung nach Anspruch 6, dadurch gekennzeichnet, daß über dem Schmelzenreservoir (8b) zur Nachführung (19) der Siliziumschmelze (9, 11) ein heizbarer Schmelztrichter (20) angeordnet ist.

8. Vorrichtung nach Anspruch 6 oder 7, dadurch gekennzeichnet, daß die Umlenkrolle (15) mit einer Wasserkühlung versehen ist.

9. Vorrichtung nach mindestens einem der Ansprüche 6 bis 8, dadurch gekennzeichnet, daß die über dem Schmelzwannenteil mit der Länge I (8a) angeordneten Reflektoren (17) als Klappen ausgebildet sind durch deren Winkelstellung die Größe des Strahlungsverlustes geregelt wird.

10. Vorrichtung nach mindestens einem der Ansprüche 6 bis 8, dadurch gekennzeichnet, daß die Reflektoren (17) plattenförmig ausgebildet sind und aus Materialien mit unterschiedlichem Reflexionsvermögen bestehen.

11. Vorrichtung nach Anspruch 10, dadurch gegekennzeichnet, daß die Reflektorplatten (17) auf einer Drehachse in Form eines Prismas angeordnet sind.

12. Vorrichtung nach mindestens einem der Ansprüche 6 bis 11, dadurch gekennzeichnet, daß die in der Schmelzwanne (8a) befindliche, mit Durchbrechungen (13) versehende Bodenplatte (12) in Richtung der Schmelzwannenhöhe h verschiebbar ist.

## Claims

1. A process for the production of strip-shaped silicon crystals for semi-conductor components, in particular for solar cells, in which a carrier body which is resistant to the silicon melt is pulled tangentially in the horizontal direction over the melt contained in a trough, and is coated with silicon, and in which the carrier body simultaneously is the crystallisation seed for the building-up of the crystalline silicon strip, characterised in that

a) as carrier body and crystallisation seed formers there are used filaments (14) which extend in parallel in the pulling direction and which consist of a material which has a higher emission factor than does the silicon melt (11),

b) for the melt (11) a trough is used whose length I is arranged to be such that a contact length L between the melt and the tangential carrier body, where L is smaller than/equal to 1, can be adjusted to be such that $L = v_z \cdot t$, where $v_z$ is the pulling speed and t is the dwell time,

c) the pulling direction ($v_z$) is set to be smaller than/equal to 10 degrees inclined to the horizontal, and

d) above the melt (11) are arranged reflectors (17) which, in association with heaters arranged beneath the bottom of the trough, regulate the radiation from the silicon melt surface (11, 22) in such manner that the temperature remains im the region of the melting point of silicon ($T_M$ = 1420°C).

2. A process as claimed in Claim 1, characterised in that for the melt (11), a trough is used whose depth h along the entire length I or a sub-length I' is arranged to be such that a constant final thickness $d_E$ of the Si-strip in the region of 100 - 400 μm can be achieved, where $d_E$ is greater than/equal to 0.05 h.

3. A process as claimed in Claim 1 and 2, characterised in that graphite, silicon carbide, quartz, graphite-coated quartz and aluminium oxide are used as material for the filaments (14).

4. A process as claimed in at least one of Claims 1 to 3, characterised in that the spacing between the filaments (14) is set in a range of between 2 and 15 mm.

5. A process as claimed in at least one of Claims 1 to 4, characterised in that with a layer thickness of the silicon strip (16) of about 300 μm and a contact length L of 150 to 200 cm, the pulling speed $v_z$ is set at about 10 cm/sec.

6. Apparatus for carrying out the process claimed in at least one of the Claims 1 to 5, characterised by the following features:

a) a melt trough (8) which accommodates the silicon melt (11) and can be heated from the bottom and which consists of a trough part (8a) with a length I and a trough part (8b) which serves as a melt reservoir, where the trough part (8a) contains a base plate (12) which extends in the horizontal direction and is provided with openings (13) whereby it is divided into an upper and a lower trough section, and where the trough part (8a) has a length I which, during the operation of the apparatus, is greater than/equal to the contact length L (where $L = v_z \cdot t$),

b) a drive device which is arranged outside the region of the melt trough (8) and by means of which a pulling direction $v_z$ smaller than/equal to 10 degrees relative to the horizontal can be set,

c) a guide roller (15), arranged laterally above the melt trough part which has the length I (8a) for the filaments (14) which produce the seed formation centres and which preferably consist of graphite,

d) a channel system (10) which is arranged in the lower part of the melt trough part which has the length I (8a) and which is linked to the trough part (8b) which serves as a reservoir for the supply melt (9) and is arranged in front of the actual pulling device (15),

e) a graphite bar (18) which is arranged in the upper part of the melt trough (8a) on the side facing towards the incoming filaments (14), and

f) reflectors (17) which are arranged above the melt trough part (8a) and which can be adjusted as regards their position in relation to the melt surface (11, 22).

7. Apparatus as claimed im Claim 6, characterised in that a heatable melt funnel (20) is arranged above the melt reservoir (8b) for the supply (19) of the silicon melt (9, 11).

8. Apparatus as claimed in Claim 6 or 7, characterised in that the guide roller (15) is provided with a water cooling arrangement.

9. Apparatus as claimed in at least one of Claims 6 to 8, characterised in that the reflectors (17) which are arranged above the melt trough part which has the length l (8a) are in the form of flaps whose angular positions regulate the extent of the radiation loss.

10. Apparatus as claimed in at least one of Claims 6 to 8, characterised in that the reflectors (17) are plate-shaped and consist of materials with different reflective capacities.

11. Apparatus as claimed in Claim 10, characterised in that the reflector plates (17) are arranged on an axis of rotation in the form of a prism.

12. Apparatus as claimed in at least one of Claims 6 to 11, characterised in that the base plate (12) which is arranged in the melt trough (8a) and is provided with openings (13) is displaceable in the direction of the melt trough height h.

## Revendications

1. Procédé pour la fabrication de cristaux de silicium en forme de bande pour des composants à semi-conducteurs, en particulier pour des cellules solaires, du type dans lequel un corps de support résistant par rapport au bain de silicium en fusion est tiré en direction horizontale et tangente au-dessus du bain en fusion contenu dans un creuset et est revêtu de silicium, et dans lequel le corps de support est en même temps le germe de cristallisation pour la réalisation de la bande de silicium cristalline, caractérisé par le fait:

a) que l'on utilise comme corps de support et comme formateur de germes de cristallisation, des fils (14) qui s'étendent parallèlement à la direction du tirage et qui sont constitués par un matériau possédant un facteur d'émission $\varepsilon$ plus grand, comparativement à celui du bain de silicium en fusion (11);

b) que l'on utilise pour le bain en fusion (11) un creuset dont la longueur (l) est telle qu'une longueur de contact (L) entre le bain en fusion et le corps de support tangent peut être ajustée, avec L plus petit/égal à l, de manière à avoir L = $v_z$ . t, avec $v_z$ désignant la vitesse du tirage et t désignant le temps de séjour;

c) que la direction du tirage ($v_z$) par rapport à l'horizontale est réglée avec une inclinaison qui est inférieure/égale à 10 degrés, et

d) que des réflecteurs (17) disposés au-dessus du bain en fusion (11) et qui coopèrent avec des éléments chauffant qui se trouvent sous le fond du creuset, règlent de telle façon le rayonnement de la surface (11, 22) du bain de silicium en fusion, que la température se maintient dans la zone du point de fusion du silicium ($T_M$ = 1420° C).

2. Procédé selon la revendication 1, caractérisé par le fait que l'on utilise pour le bain en fusion (11) un creuset dont la profondeur, sur toute la longueur (l) ou sur une longueur partielle (l'), est dimensionnée de telle façon que l'on puisse obtenir une épaisseur finale constante $d_E$ de la bande de silicium, qui se situe dans la plage de 100 - 400 μm, suivant que $d_E$ est plus grand/égal à 0,05 h.

3. Procédé selon la revendication 1 et 2, caractérisé par le fait que l'on utilise, comme matériau pour les fils (14), du graphite, du carbure de silicium, du quartz, du quartz graphité et de l'oxyde d'aluminium.

4. Procédé selon au moins l'une des revendications 1 à 3, caractérisé par le fait que la distance entre les fils (14) est réglée dans une plage se situant entre 2 et 15 mm.

5. Procédé selon au moins l'une des revendications 1 à 4, caractérisé par le fait que la vitesse de tirage ($v_z$), pour une épaisseur de couches du ruban de silicium (16) d'environ 300 μm et une longueur de contact (L) de 150 à 200 cm, est ajustée à environ 10 cm/sec.

6. Dispositif pour la mise en oeuvre du procédé selon au moins l'une des revendications 1 à 5, caractérisé par les points remarquables suivants:

a) un creuset de fusion (8) qui est susceptible d'être chauffé à partir du fond et qui reçoit le bain de silicium en fusion (11), et qui est constitué par une partie de creuset (8a) d'une longueur l et par une partie de creuset (8b) servant de réservoir de bain en fusion, alors que dans la partie de creuset (8a) est prévue, pour la séparation en une partie supérieure et une partie inférieure du creuset, une plaque de fond (12) qui s'étend en direction horizontale et qui est pourvue d'ouvertures (13), et que la partie de creuset (8a) possède une longueur l qui, lors de l'utilisation du dispositif, est supérieure/égale à la longueur de contact L (avec L = $v_z$ . t),

b) un dispositif d'entrainement disposé à l'extérieur de la zone du creuset du bain en fusion (8) et à l'aide duquel on peut régler une inclinaison de la direction de tirage $v_z$ plus petite/égale à 10 degrés par rapport à l'horizontal,

c) un galet de renvoi (15) d'une longueur l (8a) et qui est disposé latéralement au-dessus de l'élément de creuset du bain en fusion est utilisé pour les fils (14) qui provoquent les centres de formation des germes, et qui sont de préférence constitués avec du graphite,

d) un système de canaux (10) qui est disposé dans la partie inférieure de la partie de creuset de longueur l (8a) est en communication avec la partie de creuset (8b) qui sert de réservoir pour la réserve de bain (9), et qui est disposée à l'avant du dispositif de tirage proprement dit (15),

e) un barreau de graphite (18) qui se situe dans la partie supérieure du creuset (8a), du côté qui est voisin de l'entrée des fils (14), et

f) des réflecteurs (17), qui sont situés au-dessus de l'élément de creuset (8a) et dont la position est réglable par rapport à la surface du bain de fusion (11, 22).

7. Dispositif selon la revendication 6, caractérisé par le fait qu'au-dessus du réservoir du bain de fusion (8b) et qui sert à la réalimentation (19) du bain de silicium en fusion (9, 11), est disposé un entonoir (20), qui est susceptible d'être chauffé, et qui sert à la réalimentation en silicium fondu.

8. Dispositif selon la revendication 6 ou 7, caractérisé par le fait que le galet de renvoi (15) est pourvu d'un refroidissement à l'eau.

9. Dispositif selon au moins l'une des revendications 6 à 8, caractérisé par le fait que les réflecteurs (17) qui sont disposés au-dessus de l'élément de creuset de longueur I (8a) sont réalisés sous la forme de volets dont les positions angulaires permettent de régler l'importance de la perte par rayonnement.

10. Dispositif selon au moins l'une des revendications 6 à 8, caractérisé par le fait que les réflecteurs (17) sont réalisés sous la forme de plaques et sont constitués avec des matériaux ayant des pouvoirs de réflection différents.

11. Dispositif selon ia revendication 10, caractérisé par le fait que les plaques-réflecteurs (17) sont disposées sur un axe de rotation ayant la forme d'un prisme.

12. Dispositif selon au moins l'une des revendications 6 à 11, caractérisé par le fait que la plaque de fond (12) qui est située dans le creuset de bain de fusion (8a) et qui est pourvue d'ouvertures (13), est susceptible d'être déplacée en direction de la hauteur h dudit creuset.

FIG 1

FIG 2

FIG 3